# NEUE EUROPÄISCHE PATENTSCHRIFT

(11) **EP 1 123 525 B2**
(45) Veröffentlichungstag und Bekanntmachung des Hinweises auf die Entscheidung über den Einspruch: **14.02.2007**
(45) Hinweis auf die Patenterteilung: 24.07.2002
(21) Anmeldenummer: 99953551.1
(22) Anmeldetag: 20.08.1999
(51) Int. Cl.: G02B 23/24

(54) **VORRICHTUNG UND VERFAHREN ZUR OPTISCHEN INSPEKTION VERDECKTER LÖTVERBINDUNGEN**
DEVICE AND METHOD FOR THE OPTICAL INSPECTION OF CONCEALED SOLDERED CONNECTIONS
DISPOSITIF ET PROCEDE POUR L'EXAMEN OPTIQUE DE BRASURES CACHEES

(30) Priorität: 19.10.1998 DE 19847913
(43) Veröffentlichungstag der Anmeldung: 16.08.2001
(73) Patentinhaber: Ersa GmbH, 97877 Wertheim (DE)
(72) Erfinder: CANNON, Mark, D-76139 Karlsruhe (DE)
(74) Vertreter: Böck, Bernhard
(86) Internationale Anmeldenummer: PCT/DE1999/002617
(87) Internationale Veröffentlichungsnummer: WO 2000/023844

(56) Entgegenhaltungen:
- DE-A- 2 801 146
- DE-U- 29 603 327
- DE-U- 29 805 624
- DE-U- 29 806 922
- JP-A- 242 213
- JP-A- 4 047 255
- JP-A- 6 244 600
- US-A- 4 699 463
- US-A- 4 846 154
- US-A- 5 052 802
- US-A- 5 295 477
- MINISKOP Serie PKF 07/93

## Beschreibung

Die Erfindung betrifft eine Vorrichtung zur optischen Inspektion insbesondere verdeckter Lötverbindungen nach dem Oberbegriff des Patentanspruchs 1.

Weiter betrifft die Erfindung ein Verfahren nach dem Patentanspruch 16.

Im Bereich der Löttechnologie, insbesondere bei der Verwendung von SMDs (Surface Mounted Devices), und hier wiederum insbesondere bei sogenannten BGAs (Ball Grid Arrays), CSPs (Chip Scale Pakkages) und FCs (Flip Chips) tritt das Problem auf, daß aufgrund der geringen Spalthöhe zwischen der Unterseite der Bauelemente und der Platine die Qualität der Lötverbindung sowohl der außen als auch der innen liegenden Pin-Reihen zu den entsprechenden Kontaktpunkten der Platine durch bloße Inaugenscheinnahme nicht mehr kontrollierbar ist. Daher werden die entsprechenden elektrischen bzw. elektronischen Bauteile bzw. Baugruppen nach dem Löten im allgemeinen einer elektrischen Funktionsprüfung unterzogen. Dies ist zum einen jedoch zeitaufwendig und damit teuer und kann zum anderen nur eine Aussage darüber liefern, ob die Lötverbindungen stromdurchgängig bzw. ob Kurzschlüsse vorhanden sind. Eine Aussage über die Qualität und damit Dauerhaftigkeit bzw die zu erwartende Lebensdauer der einzelnen Lötverbindungen kann dieses Testverfahren nicht liefern.

Es ist ferner bekannt, Lötverbindungen zerstörungsfrei mittels Röntgenstrahlen zu überprüfen. Auch bei diesem bekannten Verfahren können letztlich nur unerwünschte einen Kurzschluß verursachende Lötbrücken zwischen benachbarten Pins bzw. die richtige Position der Pins der Bau - elemente auf den Kontaktpunkten der Platine überprüft werden; eine Aussage über die Qualität der einzelnen Lötverbindungen bzw die optische Qualität der Oberfläche der einzelnen Lötverbindungen oder beispielsweise über unerwünschte Flußmittelrückstände im Bereich der Lötungen ist nicht möglich. Zudem sind derartige Anlagen in Anschaffung und Unterhalt sehr kostspielig und die Anwendung dieses bekannten Verfahrens im Hinblick auf Strahlenbelastungen nicht ganz unbedenklich. Zudem können derartige Anlagen nur von hochqualifiziertem Fachpersonal bedient werden.

Ein weiteres bekanntes Verfahren zur Bestimmung der Qualität einer Lötverbindung ist die Herstellung eines Schliffbildes im Querschnitt durch die jeweilige Lötverbindung. Damit können zwar zuverlässige Aussagen über die Qualität der Lötverbindung, beispielsweise eine ausreichende Aufschmelzung des Lotpunktes des Bauteils und damit eine zufriedenstellende Benetzung des Kontaktpunktes auf der Platine, getroffen werden, doch handelt es sich hierbei um ein zerstörendes Prüfverfahren, das lediglich stichprobenartig Verwendung finden kann, um Rückschlüsse auf die Verfahrensparameter des Lötprozesses zu ermöglichen. Zudem ist auch hierbei eine optische Kontrolle der Oberfläche der einzelnen Lötverbindungen nicht möglich.

Schließlich sind aus dem Bereich der Medizin und der Technik Endoskope mit Beleuchtungseinrichtungen bekannt, mit denen unzugängliche Räume optisch kontrollierbar sind. Die bekannten Endoskope weisen einen im wesentlichen rohrförmigen Aufbau auf, an dessen axial äußeren Ende eine Ablenkeinheit mit Beleuchtung angeordnet ist, die den Lichtaustritt aus dem rohrförmigen Aufbau in Spaltrichtung bzw das Spaltbild in Richtung des Okulars umlenkt. Aufgrund ihrer Bauart ist jedoch der Einblick in Spalte geringer Höhe, insbesondere im Bereich unter 1 mm Spalthöhe, wie dies insbesondere bei BGAs und anderen SMDs regelmäßig der Fall ist, nicht möglich.

Ausgehend von diesem Stand der Technik ist es die Aufgabe der vorliegenden Erfindung, eine gattungsgemäße Vorrichtung zu schaffen, die in vergleichsweise einfacher und kostengünstiger Weise zerstörungsfrei die optische Inspektion insbesondere verdeckter Lötstellen ermöglicht.

Diese Aufgabe wird durch eine Vorrichtung nach der Lehre des Anspruchs 1 gelöst.

Es ist ferner eine weitere Aufgabe der Erfindung, eine Verfahren zu liefern, mit dem in einfacher Weise die Qualität einer Lötverbindung zwischen einem auf der Oberfläche einer Platine oder dergleichen angeordnetem elektrischen oder elektronischen Bauteil, insbesondere einem SMD- oder BGA-Bauteil, und der Platine überprüfbar ist.

Vorteilhafte Ausgestaltungen der Erfindung sind Gegenstand der Unteransprüche.

Erfindungsgemäß weist die Vorrichtung zur optischen Inspektion verdeckter Lötstellen, insbesondere zwischen einem elektrischen oder elektronischen auf einer Platine verlöteten Bauteil, beispielsweise einem BGA, und der Platine zur Überprüfung der Qualität der Lötverbindung, zunächst eine Okulareinheit, einen Objektivkopf, eine Bildübertragungseinheit zur Übertragung des vom Objektivkopf aufgenommenen Bildes an die Okulareinheit und eine Beleuchtungseinrichtung zur Beleuchtung der zu untersuchenden Lötverbindungen auf. Mit anderen Worten, die erfindungsgemäße Vorrichtung weist zunächst die grundsätzliche Bauweise eines technischen oder medizinischen Endoskops auf. Weiter ist in zunächst ebenfalls für sich bekannter Weise im Bereich des Objektivkopfs eine Einrichtung zur Bildablenkung vorgesehen.

Im Gegensatz zu den bekannten Endoskopen jedoch, bei denen das Objektiv bzw. die Ablenkung bauartbedingt einen zumindest geringen Abstand vom axial äußeren "distalen" Ende des Objektivkopfs aufweist, erstreckt sich bei der erfindungsgemäßen Vorrichtung die Einrichtung zur Bildablenkung bis zum axial äußeren Ende des Objektivkopfs. Bereits dadurch läßt sich der Bildaustritts- bzw- Bildeintrittspunkt des Objektives im Vergleich zum Stand derTechnik erheblich näher an die Platine legen, so daß Spalten geringerer Höhe bzw. darin angeordnete Lötstellen optisch inspizierbar sind.

Ebenfalls im Gegensatz zu den bekannten Endoskopen, bei denen die Beleuchtungseinrichtung bzw. der Lichtaustritt über oder unter dem Objektiv bzw. der Ablenkeinheit angeordnet ist, wodurch die optisch zu erreichende Spalthöhe vergrößert und/oder ein unerwünschter Lichtschatten im Spaltbereich erzeugt wird, ist erfindungsgemäß die Beleuchtungseinrichtung im Objektivkopf derart angeordnet, daß der Austrittswinkel des Lichtes der Beleuchtungseinrichtung aus dem Objektivkopf im wesentlichen gleich dem Ablenkwinkel der Bildablenkung ist und der Austrittsort des Lichtes neben der Einrichtung zur Bildablenkung im Bereich des axial äußeren Endes des Objektivkopfs angeordnet. Dies bedeutet mit anderen Worten, daß zum einen die Beleuchtungseinrichtung im wesentlichen in der gleichen Höhe, bezogen auf die Platinenoberfläche oder Spaltebene, angeordnet ist wie der Bildaustritts- bzw. Bildeintrittspunkt des Objektives und zum anderen die Bildausleuchtung ohne jegliche vertikale Abschattung erfolgt.

Insgesamt lassen sich mit der erfindungsgemäßen Vorrichtung in einfacher Weise Lötstellen in Spalten mit eine Höhe von unter 1 mm und deutlich darunter optisch inspizieren. Dies bedeutet insbesondere, daß damit die einzelnen Lötverbindungen beispielsweise bei BGAs, CSPs und FCs, die im Regelfall eine Spalthöhe von ca. 0,02 bis 0,8 mm zwischen Bauteilunterseite und Platine aufweisen, optisch auf Lötfehler, unerwünschte Brückenbildung, Verunreinigungen und dergleichen zerstörungsfrei kontrollierbar sind.

In grundsätzlich beliebiger Weise kann der Austritt des Lichtes der Beleuchtungseinrichtung einseitig am Objektivkopf erfolgen. Nach einem bevorzugten Ausführungsbeispiel der Erfindung jedoch erfolgt der Austritt des Lichtes der Beleuchtungseinrichtung aus dem Objektivkopf beidseitig neben der Einrichtung zur Bildablenkung, wodurch eine gleichmäßige Ausleuchtung des Blickfeldes sichergestellt ist.

Die Ab- bzw. Umlenkung des Bildes im Objektivkopf aus Richtung des zu beobachtenden Objekts in Richtung des Okulars kann ebenfalls in beliebiger Weise erfolgen, beispielsweise im einfachsten Fall mittels eines Umlenkspiegels. Vorzugsweise jedoch weist die Einrichtung zur Bildablenkung ein Ablenkprisma auf, in dem in an sich bekannter Weise die Umlenkung erfolgt. Damit kann im Vergleich zur Spiegelumlenkung insbesondere die optische Qualität der Abbildung verbessert und insbesondere auch der Bildautritts- bzw. Bildeintrittspunkt des Objektivs nach weiter unten, das heißt in Richtung des axial äußeren Endes des Objektivkopfs gelegt werden.

Der Ablenkwinkel der Einrichtung zur Bildablenkung ist grundsätzlich beliebigig und kann zwischen 0 und 180 Grad liegen. Dabei hängt der Ablenkwinkel im wesentlichen vom Winkel ab, in dem das Endoskop der Vorrichtung relativ zur Platinenoberfläche angestzt wird. Vorzugsweise beträgt der Ablenkwinkel im wesentlichen 90 Grad. Das heißt mit anderen Worten, daß die Vorrichtung gemäß diesem Ausführungsbeispiel der Erfindung, bezogen auf die optische Achse zwischen Objektiv und Okular im wesentlichen rechtwinklig zur Platine und damit zur Spaltebene angesetzt wird. Damit läßt sich die Vorrichtung auch bei eng bestückten Platinen und damit vergleichsweise engen Zwischenräumen zwischen den zu prüfenden Bauteilen zur Anwendung bringen.

Insbesondere wenn nicht nur die äußeren Lötverbindungen im Kantenbereich des Bauteils überprüft werden sollen, ist nach einem weiteren besonders bevorzugten Ausführungsbeispiel der Erfindung das Objektiv derart ausgelegt, daß der Tiefenschärfenbereich der Abbildung bzw. die Brennweite mindestens der halben Bauteilgröße, beispielsweise der halben Bauteilbreite, der halben Bauteillänge oder dem halben Bauteildurchmesser entspricht. Dadurch kann durch Inspektion von jeweils gegenüberliegenden Seiten des Bauteils der gesamte Spaltinnenraum optisch kontrolliert werden. Der Tiefenschärfenbereich des Objektivs kann dabei in an sich bekannter Weise beispielsweise durch die Brennweite des Objektivs voreingestellt werden.

Nach einem besonders bevorzugten Ausführungsbeispiel weist der Objektivkopf ein Gehäuse mit mindestens einer seitlich offenen und zum axial äußeren Ende des Objektivkopfs hin auslaufenden Ausnehmung, die beidseitig von flanschartigen Stegen begrenzt wird, auf. Dabei ist in diesem Gehäuse das Ablenkprisma bzw. der Ablenkspiegel derart angeordnet, daß die freie, das heißt die zum Spalt weisende Fläche des Ablenkprismas bzw. die Spiegelfläche in der Ausnehmung nach außen, bezogen auf das Gehäuse und die Ausnehmung, weist und die untere Seitenkante des Ablenkprismas bzw. des Ablenkspiegels den Objektivkopf zum axial äußeren Ende hin abschließt. Dies bedeutet mit anderen Worten, daß das untere Ende des Ablenkprismas bzw. des Ablenkspiegels unmittelbar zur Anlage an die Platine bringbar ist, um eine Bildumlenkung auch in niedrigste Spalte zu gewährleisten, während die Seitenkanten des Prismas bzw. des Spiegels durch die flanschartigen Stege gegen Beschädigung geschützt werden und gleichzeitig das Prisma bzw. der Spiegel durch diese Stege fixierbar ist. Bei diesem Ausführungsbeispiel können ferner die Lichtaustritte der Beleuchtungseinrichtung in den flanschartigen Stegen angeordnet sein.

Nach einem weiteren bevorzugten Ausführungsbeispiel weist die Beleuchtungseinrichtung mindestens ein Glasfaserbündel auf, das mit seinem ersten axialen Ende an eine Lichtquelle, sei diese nun extern oder aber in oder an der Vorrichtung angeordnet, anschließbar ist und mit seinem zweiten axialen Ende den Lichtaustritt der Beleuchtungseinrichtung am Objektivkopf bildet. Durch die Verwendung eines Glasfaserbündels kann in einfacher Weise insbesondere ein Lichtaustritt realisiert werden, der bei ausreichender Beleuchtungsstärke einen genügend kleinen Durchmesser zur Beleuchtung eines engen Spaltes aufweist. Falls zwei oder mehrere Lichtaustritte im Objektivkopf vorhanden sind, können die jeweiligen Glasfaserbündel zwischen Lichtaustritt und Lichtquelle zu einem Bündel zusammengefaßt und einer gemeinsamen Lichtquelle zugeführt werden.

Die Übertragung des Spaltbildes vom Objektivkopf an das Okular kann beispielsweise durch ein Linsen- oder Spiegelsystem erfolgen. Vorzugsweise jedoch weist die erfindungsgemäße Vorrichtung zur Bildübertragung mindestens ein weiteres Glasfaserbündel, das mit seinem ersten Ende an die Einheit zur Bildablenkung, insbesondere das Ablenkprisma, und mit seinem zweiten Ende an das Okular optisch ankoppelbar ist.

Grundsätzlich lassen sich mit den vorstehend beschriebenen Ausführungsbeispielen alle Arten von Lötfehlern sowohl im Randbereich als auch, bei ausreichender Tiefenschärfe des Objektivs, im inneren Bereich des Lötfeldes beispielsweise eines BGA, eines CSP oder eines FC optisch kontrollieren und ermitteln. Insbesondere, jedoch keineswegs ausschließlich, wenn es darum geht, unerwünschte einen Kurzschluß verursachende Lötbrücken zwischen benachbarten "Lötpins" eines BGA, eines CSP oder eines FC mit einer Vielzahl von Lötpunkten zu entdecken, ist nach einem besonders bevorzugten Ausführungsbeispiel der Erfindung eine zweite Beleuchtungseinrichtung vorgesehen, die im wesentlichen in Blick- bzw. in Bildrichtung, bezogen auf die Spaltebene, der Vorrichtung dem Objektivkopf gegenüber positionierbar ist und in Richtung zum Objektivkopf leuchtet. Damit läßt sich in einfacher Weise beim Durchblick durch die Spaltzwischenräume zwischen den einzelnen Reihen der Lötpunkte durch Erkennen der Gegenlichtquelle eine Kurzschlußbrücke ausschließen und, umgekehrt, in eindeutiger Weise eine unerwünschte Brücke ermitteln, falls die Gegenlichtquelle nicht zu sehen ist.

Nach einem weiteren Ausführungsbeispiel der Erfindung weist die zweite Beleuchtungseinrichtung einen Gegenlichtkopf mit einem Gehäuse mit mindestens einer seitlich offenen und zum axial äußeren Ende des Gegenlichtkopfs hin auslaufenden Ausnehmung auf, wobei im Gehäuse ein Ablenkprisma oder ein Ablenkspiegel, das bzw. der über ein Glasfaserbündel an eine Lichtquelle anschließbar ist, derart angeordnet ist, daß die freie Fläche des Ablenkprismas bzw. die Spiegelfläche in der Ausnehmung nach außen weist und die untere Seitenkante des Ablenkprismas bzw. des Ablenkspiegels den Gegenlichtkopf zum axial äußeren Ende hin abschließt. Dies bedeutet mit anderen Worten, daß die Lichtumlenkung und der Lichtaustritt über das Prisma erfolgen, das bei diesem Ausführungsbeispiel keinerlei bildübertragende Funktion aufweist. Aufgrund der vorbeschriebene Gestaltung kann das Prisma und damit der Lichtaustritt wiederum nahe an die Platinenoberfläche und damit in die Spaltebene gelegt werden.

Nach einem dazu alternativen Ausführungsbeispiel kann die zweite Beleuchtungseinrichtung einen Gegenlichtkopf aufweisen, der im wesentlichen identisch zum Objektivkopf der Vorrichtung aufgebaut ist. Bei diesem Ausführungsbeispiel können der Gegenlichtkopf und der Objektivkopf jeweils gleichzeitig oder alternierend als Beleuchtungseinrichtung und/oder Bildaufnehmer dienen, so daß gleichzeitig oder alternierend der Spalt von beiden Seiten beispielsweise eines BGAs kontrolliert werden kann. Dazu kann das Prisma des Gegenlichtkopfes umschaltbar mit dem Okular des Objektivkopfes oder aber mit einem separaten Okular optisch koppelbar sein.

Insbesondere wenn der Gegenlichtkopf lediglich als Gegenlichtquelle dient, kann nach einem weiteren Ausführungsbeispiel der Erfindung das Glasfaserbündel zumindest der zweiten Beleuchtungseinrichtung in einem flexiblen Spiralschlauch verlaufen. Dadurch ist zum einen das Glasfaserbündel gegen mechanische Beschädigungen zuverlässig geschützt und zum anderen läßt sich dadurch der Gegenlichtkopf in Anpassung an BGAs unterschiedlicher Abmessungen insbesondere in seiner Entfernung zum Objektivkopf verstellen.

Die Beleuchtungseinrichtung des Gegenlichtkopfs und die Beleuchtungseinrichtung des Objektivkopfes können in beliebiger Weise an unterschiedliche Lichtquellen angekoppelt sein. Vorzugsweise jedoch sind die Glasfaserbündel des Objektivkopfes und des Gegenlichtkopfes an die gleiche Lichtquelle anschließbar. Dadurch ergibt sich insgesamt eine einfache und kostengünstige bauliche Gestaltung.

Nach einem weiteren Ausführungsbeispiel können die erste und/oder die zweite Beleuchtungseinrichtung bzw. die Lichtquelle der ersten und/oder zweiten Beleuchtungseinrichtung in ihrer Leuchtstärke bzw. Lichtintensität einstellbar sein.

Es ist für die Erfindung von wesentlicher Bedeutung, daß der Objektivkopf von der Gegenlichtquelle beleuchtbar ist. Dazu sind vorzugsweise der Objektivkopf und die zweite Beleuchtungseinrichtung über ein Gestänge, Gestell oder dergleichen derart koppelbar, daß eine genau definierte Relativposition von Objektivkopf und Beleuchtungseinrichtung, insbesondere Gegenlichtkopf, einstellbar ist.

Nach einem besonders bevorzugten Ausführungsbeispiel weist dazu das Gestänge oder Gestell einen Träger auf, der an einem Gehäuseabschnitt der Vorrichtung zwischen Objektivkopf und Okular frei auskragend im wesentlichen starr befestigbar oder Teil dieses Gehäuseabschnitts ist. Dabei weist der Träger ein in Längsrichtung in einer Führung verschiebbares Halteelement, in dem die zweite Beleuchtungseinrichtung mittelbar oder unmittelbar fixierbar ist und mit dem insbesondere der axiale Abstand zwischen Objektivkopf und Gegenlichtkopf verstellbar ist, auf.

Das vom Objektiv an das Okular übermittelte Abbild des Spaltes bzw. der darin angeordneten Lötstellen kann am Okular unmittelbar von einem Beobachter betrachtet werden. Nach einem bevorzugten Ausführungsbeispiel jedoch ist eine elektronisch, magnetisch oder optisch bildaufzeichnende, bildumwandelnde und/oder bildverarbeitende Einrichtung im Bereich des Okulars mittelbar oder unmittelbar ankoppelbar. Dies kann beispielsweise eine Video- oder Fernsehkamera sein, deren CCD-Bildwandler unmittelbar oder mittelbar über ein entsprechendes Objektiv an das Okular anschließbar ist. Das so aufgenommene Videobild kann auf einen Bildschirm gegeben und/oder in einem Rechner einer Bildverarbeitung unterzogen werden. Damit läßt sich die Überprüfung von Lötstellen unter einem BGA in grundsätzlich beliebiger Weise beispielsweise durch Bildvergleich mit Referenzbildern automatisieren. Dabei kann insbesondere auch die Spalthöhe ermittelt und gemessen und gegebenenfalls mit einer kritischen Spalthöhe verglichen werden.

Die erfindungsgemäße Vorrichtung kann in an sich bekannter Weise auf einem X-Y-Tisch angeordnet sein, auf dem eine zu untersuchende Platinen-Bauteil-Lötverbindung in die Prüfposition unter der Vorrichtung oder, umgekehrt, die Vorrichtung in die Prüfposition über der Platinen-Bautell-Lötverbindung gebracht werden kann.

Erfindungsgemäß kann die vorbeschriebene Vorrichtung in besonders vorteilhafter Weise in einem Verfahren zur Überprüfung der Qualität der Lötverbindung zwischen einem auf der Oberfläche einer Platine oder dergleichen angeordneten elektrischen oder elektronischem Bauteil, insbesondere einem SMD- oder BGA-Bauteil und der Platine, Verwendung finden. Das Hinsichtlich der Lötverbindung zur Platine zu untersuchende Bauteil weist eine Vielzahl von nach Art einer Matrix in Reihen und Spalten angeordneten Lötpins oder Lötpunkten auf, die mit einer entsprechenden Anzahl von form- und funktionskomplementär auf der Platine angeordneten Kontaktpunkten verlötbar sind. Das erfindungsgemäße Verfahren weist folgende Verfahrensschritte auf:
a) In einem ersten Verfahrensschritt erfolgt zunächst eine optische Untersuchung der Lötverbindungen der äußersten Reihe von Lötverbindungen einer ersten Seite des zu untersuchenden Bauteils, wobei das Bauteil schrittweise dem Abstand der Lötpunktreihen bzw. -spalten entsprechend am Objektivkopf der Vorrichtung oder, umgekehrt, der Objektivkopf der Vorrichtung schrittweise am Bauteil vorbeigeführt wird. Dabei müssen nicht notwendigerweise sämtliche Lötpunkte überprüft werden; vielmehr kann bereits durch die Überprüfung der Ecklötstellen eine vergleichsweise zuverlässige Aussage über die Qualität der Lötung insgesamt getroffen werden. Dabei kann sowohl die Oberfläche der Lötverbindung, insbesondere auch Flußmittelrückstände, als auch beispielsweise die geometrische Form des Lötpunktes, insbesondere die "Balligkeit" bei den Lötpunkten eines BGA als Maß für ein ausreichendes Aufschmelzen beim Lötvorgang und die Co-Planarität von Bauteil und Platine, zur Beurteilung der Qualität der Lötverbindung herangezogen werden. Ein weiteres Maß für die Qualität der Lötverbindung bzw. zumindest ein ausreichendes Aufschmelzen der Lötpunkte beim Lötvorgang kann der Abstand der Bauteilunterseite von der Platinenoberfläche sein. Dieser kann als Spalthöhe mit einer erfindungsgemäßen Vorrichtung leicht gemessen werden.
b) In weiteren Verfahrensschritten wird das Bauteil oder die Vorrichtung jeweils um 90 Grad gedreht, wobei nachfolgend jeweils eine optische Untersuchung der äußersten Reihen von Lötverbindungen der weiteren Seiten des Bauteils analog dem Verfahrensschritt a) erfolgt.
c) Zur sicheren Ermittlung von unerwünschten Brücken zwischen benachbarten Lötpins, die zu einem elektrischen Versagen des Bauteils führen können, erfolgt erfindungsgemäß in einem weiteren Verfahrensschritt eine optische Untersuchung der jeweils zwischen den Spalten bzw. Reihen gebildeten Kanälen auf Durchsicht.

Die Verfahrensschritte a) bis c) müssen nicht notwendigerweise zeitlich in dieser Reihenfolge durchgeführt werden. Vielmehr kann insbesondere der Verfahrensschritt c) zeitgleich zu den Verfahrensschritten a) und b) beim schrittweisen Vorbeiführen des Bauteils am Objektivkopf oder, umgekehrt, des Objektivkopfs am Bauteil durchgeführt werden.

Nach einem bevorzugten Ausführungsbeispiel wird der Verfahrensschritt c) im Gegenlicht durchgeführt, wodurch sich eine besonders leichte und schnelle Erkennbarkeit unerwünschter Kurzschlußbrücken ergibt.

Um ein Bauteil bzw. die Lötverbindungen zwischen dem Bauteil und der Platine vollständig zu überprüfen, können bei den Verfahrensschritten a) und b), zeitgleich oder zeitlich versetzt, die Lötverbindungen der inneren Reihen durch Einblick in die zwischen den Spalten bzw. Reihen gebildeten Kanäle optisch auf Lötfehler untersucht werden. Dadurch können insbesondere Co-Planaritätsfehler zwischen Bauteil und Platine im Spaltinnenraum leicht und zuverlässig ermittelt werden.

Im folgenden wird die Erfindung anhand lediglich ein Ausführungsbeispiel darstellender Zeichnungen näher erläutert. Es zeigt
- **Fig. 1**: in schematischer Darstellung ein Ausführungsbeispiel der erfindungsgemäßen Vorrichtung in Ansicht;
- **Fig. 2**: in vergrößerter schematischer teilweise aufgebrochener Darstellung den Objektivkopf des Ausführungsbeispiels nach Fig. 1, wobei der Objektivkopf gegenüber der Darstellung nach Fig. 1 um 90 Grad verdreht ist; und
- **Fig. 3**: in vergrößerter schematischer der Fig. 2 entsprechenden Darstellung den Gegenlichtkopf der erfindungsgemäßen Vorrichtung.

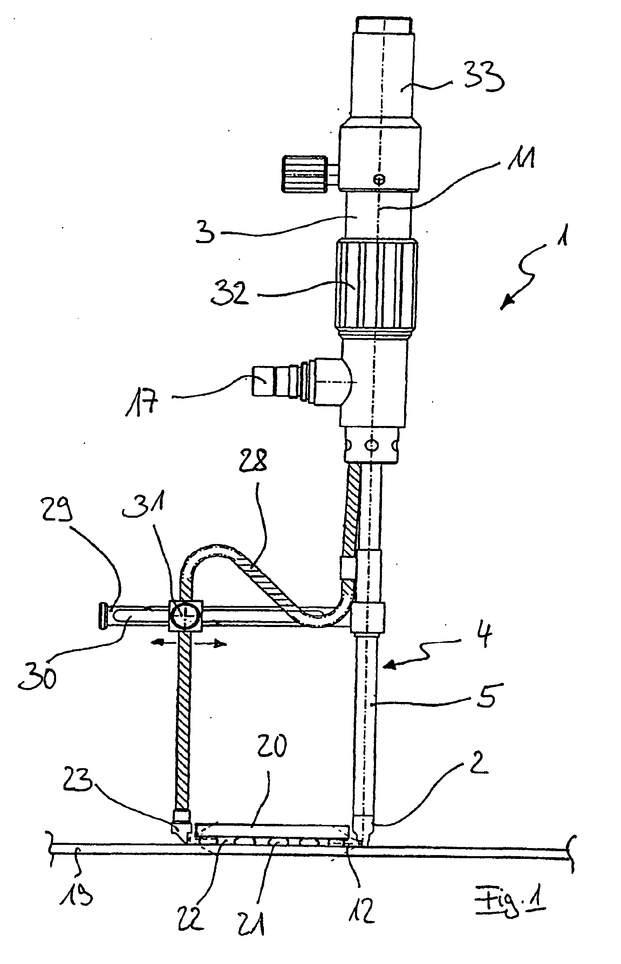

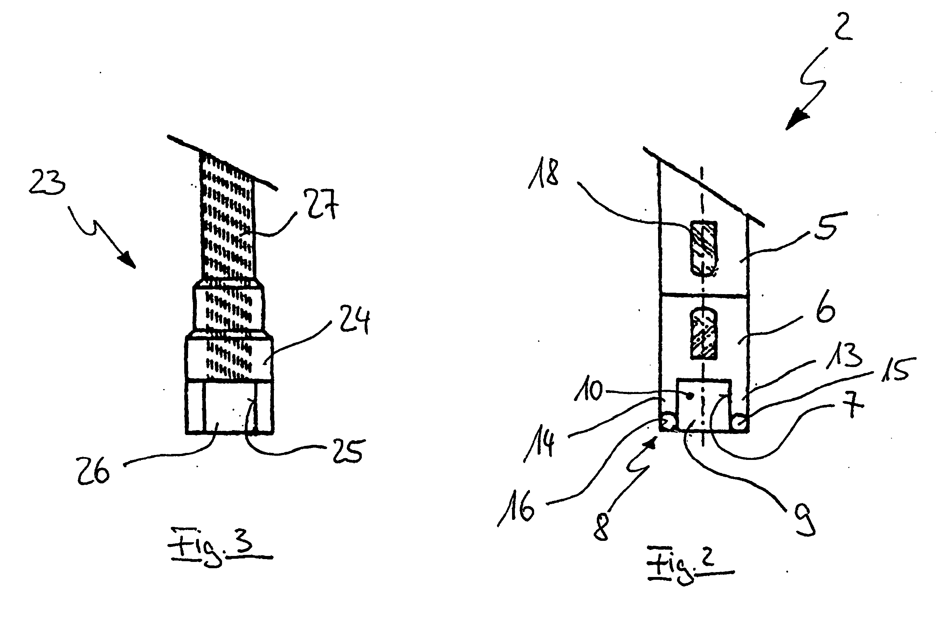

Die in Fig. dargestellte erfindungsgemäße Vorrichtung 1 weist im wesentlichen die äußere Gestalt eines Endoskops auf. Die Vorrichtung 1 ist dabei mit einem Objektivkopf 2, der in an sich bekannter Weise ein Objektiv enthält, einer Okulareinheit 3 und einer Bildübertragungseinheit 4 zur Übertragung des vom Objektivkopf 2 aufgenommenen Bildes an die Okulareinheit 3 ausgestattet. Die Bildübertragungseinheit 4 ist in einem im wesentlichen rohrförmigen Gehäuseabschnitt 5 der Vorrichtung 1 angeordnet und weist ein in der Darstellung nach Fig. 2 lediglich schematisch angedeutetes Glasfaserbündel 18 auf, das den Objektivkopf mit der Okulareinheit 3 optisch, das heißt bildübertragend, koppelt. Alternativ oder zusätzlich zum Glasfaserbündel kann eine Linsengruppe zwischen Objektivkopf und Okulareinheit zur Übertragung und gegebenenfalls Vergrößerung des aufgenommenen Bildes angeordnet sein

Der Objektivkopf 2, der in Fig. 2 vergrößert dargestellt ist, weist ein Gehäuse 6, vorzugsweise aus Edelstahl, auf, das im Querschnitt trichterförmig (vgl. Fig. 1) geformt ist. Das Gehäuse 6 ist mit einer Ausnehmung 7 versehen, die in Darstellung nach Fig. 2 im wesentlichen quadratisch ausgebildet ist. Die Ausnehmung 7 ist dabei sowohl nach unten, das heißt zum axial äußeren Ende 8 der Vorrichtung 1 hin als auch seitlich, das heißt in der Darstellung nach Fig. 1 zum Betrachter hin, offen. In der Ausnehmung 7 ist ein Ablenkprisma 9 so angeordnet, daß die freie Prismenfläche 10 nach außen (in der Darstellung nach Fig. 1 nach links) weist und eine Ab- bzw Umlenkung des Strahlengangs um 90 Grad aus der durch Okulareinheit 3 und Objektivkopf gebildeten Vertikalachse 11 in die Horizontalachse 12 und umgekehrt stattfindet.

Die Ausnehmung 7 wird durch zwei flanschartige Stege 13 und 14 seitlich begrenzt. Diese Stege dienen zum einen zur Fixierung und zum Schutz des Ablenkprismas 9 gegen mechanische Beschädigung und zum anderen sind in den axial äußeren Enden der Stege 13 und 14 Lichtaustritte 15 und 16 angeordnet, die Teil einer Beleuchtungseinrichtung sind. Die Lichtaustritte 15 und 16 werden bei diesem Ausführungsbeispiel durch die freien axialen Enden jeweils eines Glasfaserbündels gebildet, die durch den Objektivkopf 2 und den Gehäuseabschnitt 5 zu einem Glasfaseranschluß 17 geführt sind, der zur Einspeisung des Lichtes einer nicht dargestellten Lichtquelle dient, so daß beide Lichtaustritte 15 und 16 von derselben Lichtquelle gespeist werden. Die Glasfaserbündel sind im Bereich der Lichtaustritte so orientiert, daß der Austrittswinkel des Lichtes im wesentlichen gleich dem Ablenkwinkel der Bildablenkung ist, wodurch das gesamte optisch erreichbare Blickfeld ohne jegliche vertikale Verschattung beleuchtbar ist.

In Fig. 1 ist die erfindungsgemäße Vorrichtung 1, genauer der Objektivkopf 2 bestimmungsgemäß auf eine Platine aufgesetzt oder mit nur geringem Abstand über der Platinenoberfläche gehalten. Auf der Platine ist in bekannter Weise ein elektronisches Bauteil 20 in Form eines BGA (Ball Grid Array) durch Verlöten über die Lötstellen 21 befestigt. Der Spalt 22 zwischen der Bauteilunterseite und der Platinenoberfläche, der nicht maßstäblich stark vergrößert dargestellt ist, weist in der Regel zwischen 0,02 und 0,8 mm Spalthöhe auf. Aufgrund der oben beschriebenen Merkmale der Erfindung, insbesondere der Anordnung des Ablenkprismas 9 bis unmittelbar zum axial äußersten distalen Ende des Objektivkopfs 2 kann der Bildaustritts- bzw. Bildeintrittspunkt des Prismas und damit des Objektivs insgesamt in den Spaltbereich gelegt werden, wodurch der Spalt und damit die darin angeordneten inneren Lötverbindungen optisch zugänglich werden, wobei zudem aufgrund des Lichtaustritts in im wesentlichen gleicher axialer Höhe über der Platinenoberfläche wie der Bildaustritts- bzw. Bildeintrittspunkt eine ausreichende Beleuchtung und damit gute Beobachtbarkeit im Spaltbereich sichergestellt ist.

Das in Fig. 1 dargestellte Ausführungsbeispiel einer erfindungsgemäßen Vorrichtung 1 ist ferner mit einem Gegenlichtkopf 23 ausgestattet. Der Gegenlichtkopf 23 weist ein Gehäuse 24 (vg. Fig. 3) auf, das in analoger Weise zum Gehäuse 6 des Objektivkopfes 2 mit einer Ausnehmung 25 und einem darin wie oben beim Objektivkopf 2 beschrieben angeordneten Ablenkprisma 26 versehen ist. Im Gegensatz zum Objektivkopf 2 ist jedoch das Ablenkprisma 26 optisch nicht mit der Okulareinheit 3 verbunden, sondern vielmehr über ein Glasfaserbündel 27, das in einem flexiblen Spiralschlauch 28, insbesondere aus Edelstahl, geführt ist, mit dem Glasfaseranschluß 17 und damit der selben nicht dargestellten Lichtquelle wie die Beleuchtungseinrichtung des Objektivkopfes 2. Das Ablenkprisma 26 dient dabei im wesentlichen der im wesentlichen auf den Objektivkopf 2 gerichteten Einleitung von Gegenlicht in den Spalt 22.

Im Bereich des Gehäuseabschnitts 5 ist ein frei auskragender Träger 29 an der Vorrichtung 1 befestigt. Dabei ist im Träger 29 eine nutartige Führung 30 ausgebildet, in der ein Klemmstück 31 axial, das heißt in axialer Richtung des Trägers 29, verschiebbar und klemmbar fixierbar geführt ist. Im Klemmstück 31 ist das im Spiralschlauch 28 verlaufende Glasaserbündel 27 gehalten, so daß mit der Verschiebung des Klemmstücks 30 gleichzeitig der Gegenlichtkopf 23 in Pfeilrichtung verschiebbar und somit der genaue Abstand von Gegenlichtkopf 23 und Objektivkopf 2 insbesondere in Anpassung an unterschiedlich große BGA-Bau teile einstellbar ist. Ferner kann der Träger bezüglich des Gehäuseabschnitts 5 höhenverstellbar und um mindestens 90° verdrehbar ausgebildet sein, um den Träger und damit den Gegenlichtkopf aus der Arbeitsstellung in eine Ruhestellung zu bringen, falls dieser nicht gebraucht wird, und umgekehrt.

Im Bereich der Okulareinheit 3 ist die Vorrichtung 1 mit einer Fokussierung 32 zur Scharfstellung der optischen Abbildung versehen. Weiter ist an die Okulareinheit 3 ein Video-Objektiv 33 optisch angekoppelt, um das aufgenommene Spaltbild einer optischen Bildverarbeitung oder Bildspeicherung zuzuführen. Weiter kann ein TV-Zoom-Adapter zwischen der Kamera und der Okulareinheit angeordnet sein, um das übertragene Bild entsprechend zu vergrößern.

## Patentansprüche

1. Vorrichtung zur optischen Inspektion insbesondere verdeckter Lötverbindungen (21), insbesondere zwischen einem auf der Oberfläche einer Platine (19) angeordneten elektrischen oder elektronischen Bauteil (20) und der Platine (19), mit einer Okulareinheit (3), einem Objektivkopf (2), einer Bildübertragungseinheit (4) zur Übertragung des vom Objektivkopf (2) aufgenommenen Bildes an die Okulareinheit (3) und einer Beleuchtungseinrichtung (15, 16) zur Beleuchtung der zu untersuchenden Lötverbindungen (21), wobei der Objektivkopf (2) eine Einrichtung zur Bildablenkung (9) aufweist, die sich bis zum axial äußeren Ende des Objektivkopfs (2) erstreckt, und wobei die Beleuchtungseinrichtung (15, 16) im Objektivkopf (2) derart angeordnet ist, daß der Austrittswinkel des Lichtes der Beleuchtungseinrichtung (15, 16) aus dem Objektivkopf (2) im wesentlichen gleich dem Ablenkwinkel der Bildablenkung (9) ist und der Austrittsort des Lichtes seitlich der Einrichtung zur Bildablenkung (9) im Bereich des axial äußeren Endes des Objektivkopfs (2) angeordnet ist.

2. Vorrichtung nach Anspruch 1,
**dadurch gekennzeichnet,**
**daß** der Austritt (15, 16) des Lichtes der Beleuchtungseinrichtung aus dem Objektivkopf (2) beidseitig neben der Einrichtung zur Bildablenkung (9) erfolgt.

3. Vorrichtung nach Anspruch 1 oder 2,
**dadurch gekennzeichnet,**
**daß** die Einrichtung zur Bildablenkung mindestens ein Ablenkprisma (9) oder mindestens einen Ablenkspiegel aufweist.

4. Vorrichtung nach einem der Ansprüche 1 bis 3,
**dadurch gekennzeichnet,**
**daß** der Ablenkwinkel der Einrichtung zur Bildablenkung (9) zwischen 0 und 180 Grad, vorzugsweise im wesentlichen 90 Grad, beträgt.

5. Vorrichtung nach einem der Ansprüche 1 bis 4,
**dadurch gekennzeichnet,**
**daß** das Objektiv derart ausgelegt ist, insbesondere eine Brennweite derart aufweist, daß der Tiefenschärfenbereich der Abbildung mindestens der halben Bauteilgröße entspricht.

6. Vorrichtung nach einem der Ansprüche 1 bis 5,
**dadurch gekennzeichnet,**
**daß** der Objektivkopf (2) ein Gehäuse (6) mit mindestens einer seitlich offenen und zum axial äußeren Ende des Objektivkopfs (2) hin auslaufenden Ausnehmung (7) aufweist, die beidseitig von flanschartigen Stegen (13,14) begrenztwird, wobei im Gehäuse (6) das Ablenk-prisma (9) oder der Ablenkspiegel derart angeordnet ist, daß die freie Fläche (10) des Ablenkprismas (9) oder die Spiegelfläche in der Ausnehmung (7) nach außen weist und die untere Seitenkante des Ablenkprismas (9) oder des Ablenkspiegels den Objektivkopf (2) zum axial äußeren Ende (8) hin abschließt und wobei ferner die Lichtaustritte (15, 16) der Beleuchtungseinrichtung in den flanschartigen Stegen (13, 14) angeordnet sind.

7. Vorrichtung nach einem der Ansprüche 1 bis 6,
**dadurch gekennzeichnet,**
**daß** die Beleuchtungseinrichtung (15, 16) mindestens ein Glasfaserbündel aufweist, das mit seinem ersten axialen Ende an eine Lichtquelle anschließbar ist und mit seinem zweiten axialen Ende den Lichtaustritt (15, 16) der Beleuchtungseinrichtung am Objektivkopf (2) bildet.

8. Vorrichtung nach einem der Ansprüche 1 bis 7,
**dadurch gekennzeichnet,**
**daß** die Bildübertragungseinheit (4) mindestens ein Glasfaserbündel (18) aufweist, das mit seinem ersten Ende an die Einheit zur Bildablenkung, insbesondere das Ablenkprisma (9), und mit seinem zweiten Ende an die Okulareinheit (3) optisch ankoppelbar ist.

9. Vorrichtung nach einem der Ansprüche 1 bis 8, **gekennzeichnet durch**
eine zweite Beleuchtungseinrichtung, die im wesentlichen in Blickrichtung der Vorrichtung (1) dem Objektivkopf (2) gegenüber positionierbar ist und in Richtung zum Objektivkopf (2) leuchtet.

10. Vorrichtung nach Anspruch 9,
**dadurch gekennzeichnet,**
**daß** die zweite Beleuchtungseinrichtung einen Gegenlichtkopf (23) mit einem Gehäuse (24) mit mindestens einer seitlich offenen und zum axial äußeren Ende des Gegenlichtkopfs (23) hin auslaufenden Ausnehmung (25) aufweist, wobei im Gehäuse (24) ein Ablenkprisma (26) oder ein Ablenkspiegel, das bzw. der über ein Glasfaserbündel (27) an eine Lichtquelle optisch ankoppelbar ist, derart angeordnet ist, daß die freie Fläche des Ablenkprismas (26) bzw. die Spiegelfläche in der Ausnehmung (25) nach außen weist und die untere Seitenkante des Ablenkprismas (26) bzw. des Ablenkspiegels den Gegenlichtkopf (23) zum axial äußeren Ende hin abschließt.

11. Vorrichtung nach Anspruch 9,
**dadurch gekennzeichnet,**
**daß** die zweite Beleuchtungseinrichtung einen Gegenlichtkopf (23) aufweist, der im wesentlichen identisch zum Objektivkopf (2) aufgebaut ist

12. Vorrichtung nach einem der Ansprüche 9 bis 11,
**dadurch gekennzeichnet,**
**daß** das Glasfaserbündel (27) zumindest der zweiten Beleuchtungseinrichtung in einem flexiblen Spiralschlauch (28) verläuft.

13. Vorrichtung nach einem der Ansprüche 9 bis 12,
**dadurch gekennzeichnet,**
**daß** die Glasfaserbündel des Objektivkopfes (2) und des Gegenlichtkopfes (23) an die gleiche Lichtquelle anschließbar sind.

14. Vorrichtung nach einem der Ansprüche 1 bis 13,
**dadurch gekennzeichnet,**
**daß** die erste und/oder die zweite Beleuchtungseinrichtung bzw. die Lichtquelle der ersten und/oder zweiten Beleuchtungseinrichtung in ihrer Leuchtstärke bzw. Lichtintensität einstellbar sind.

15. Vorrichtung nach einem der Ansprüche 9 bis 14,
**dadurch gekennzeichnet,**
**daß** der Objektivkopf (2) und die zweite Beleuchtungseinrichtung über ein Gestänge, Gestell oder dergleichen derart koppelbar sind, daß eine genau definierte Relativposition von Objektivkopf (2) und zweiter Beleuchtungseinrichtung, insbesondere Gegenlichtkopf (23), einstellbar ist.

16. Vorrichtung nach Anspruch 15,
**dadurch gekennzeichnet,**
**daß** das Gestänge oder Gestell einen Träger (29) aufweist, der an einem Gehäuseabschnitt (5) der Vorrichtung (1) zwischen Objektivkopf (2) und Okulareinheit (3) frei auskragend im wesentlichen starr befestigbar oder Teil dieses Gehäuseabschnitts (5) ist, wobei der Träger (29) ein in Längsrichtung in einer Führung (30) verschiebbares Halteelement (31), in dem die zweite Beleuchtungseinrichtung fixierbar ist, aufweist, mit dem der axiale Abstand zwischen Objektivkopf (2) und Gegenlichtkopf (23) verstellbar ist.

17. Vorrichtung nach einem der Ansprüche 1 bis 16,
**dadurch gekennzeichnet,**
**daß** eine elektronisch, optisch oder magnetisch bildaufzeichnende, bildumwandelnde und/oder bildverarbeitende Einrichtung im Bereich der Okulareinheit (3) mittelbar oder unmittelbar bildübertragend ankoppelbar ist.

18. Verfahren zur Überprüfung der Qualität der Lötverbindung zwischen einem auf der Oberfläche einer Platine oder dergleichen angeordneten elektrischen oder elektronischem Bauteil und der Platine, unter Verwendung der Vorrichtung nach einem der vorstehenden Ansprüche, wobei das Bauteil eine Vielzahl von nach Art einer Matrix in Reihen und Spalten angeordneten Lötpins, Lötkugeln oder Lötpunkten aufweist, die mit einer entsprechenden Anzahl von form- und funktionskomplementär auf der Platine angeordneten Kontaktpunkten verlötbar sind, mit folgenden Verfahrensschritten:
a) optische Untersuchung der Lötverbindungen der äußersten Reihe von Lötverbindungen einer ersten Seite des zu untersuchenden Bauteils, wobei das Bauteil schrittweise dem Abstand der Lötpunktreihen bzw. -spalten entsprechend am Objektivkopf der Vorrichtung oder, umgekehrt, der Objektivkopf der Vorrichtung schrittweise am Bauteil vorbeigeführt wird;
b) Drehen des Bauteils oder der Vorrichtung um jeweils 90 Grad und optische Untersuchung analog dem Verfahrensschritt a) der Lötverbindungen der äußersten Reihen von Lötverbindungen der weiteren Seiten des Bauteils; und
c) optische Untersuchung der jeweils zwischen den Spalten bzw. Reihen gebildeten Kanälen auf Durchsicht.

19. Verfahren nach Anspruch 18,
**dadurch gekennzeichnet,**
**dass** das elektrische oder elektronische Bauteil ein SMD oder BGA ist.

20. Verfahren nach Anspruch 18 oder 19,
**dadurch gekennzeichnet,**
**daß** Verfahrensschritt c) im Gegenlicht durchgeführt wird.

21. Verfahren nach Anspruch 18, 19 oder 20,
**dadurch gekennzeichnet,**
**daß** zusätzlich zu den Verfahrensschritt a) und b) zeitgleich oder zeitversetzt die Lötverbindung der inneren Reihen durch Einblick in die zwischen den Spalten bzw. Reihen gebildeten Kanäle optisch auf Lötfehler untersucht werden.

## Claims

1. Apparatus for the visual inspection in particular of concealed soldered joints (21), in particular between an electric or electronic component (20) disposed on the surface of a printed circuit board (19) and the printed circuit board (19), with an ocular unit (3), a lens head (2), an image transmission unit (4) for transmitting the image received by the lens head (2) to the ocular unit (3) and an illuminating device (15, 16) for illuminating the soldered joints (21) to be tested, in which the lens head (2) comprises a device for image deviation (9) which extends up to the axially outer end of the lens head (2), and in which the illuminating device (15, 16) is disposed in the lens head (2) in such a way that the exit angle of the light of the illuminating device (15, 16) out of the lens head (2) is substantially equal to the deviation angle of the image deviation (9) and the exit point of the light is disposed laterally to the device for image deviation (9) in the area of the axially outer end of the lens head (2).

2. Apparatus according to claim 1,
**characterised in that**
the exit (15, 16) of the light of the illuminating device from the lens head (2) takes place bilaterally next to the device for image deviation (9).

3. Apparatus according to claim 1 or 2,
**characterised in that**
the device for image deviation comprises at least one deviating prism (9) or at least one deviating mirror.

4. Apparatus according to any one of claims 1 to 3,
**characterised in that**
the deviation angle of the device for image deviation (9) comes to between 0 and 180 degrees, preferably substantially 90 degrees.

5. Apparatus according to any one of claims 1 to 4,
**characterised in that**
the lens is constructed in such a way that it, in particular, has a focal length such that the depth of field area of the image corresponds to at least half the component size.

6. Apparatus according to any one of claims 1 to 5,
**characterised in that** the lens head (2) comprises a housing (6) with at least one laterally open recess (7) tapering towards the axially outer end of the lens head (2) and bounded on both sides by flange-type webs (13, 14), wherein in the housing (6) the deviating prism (9) or the deviating mirror is disposed in such a way that the free surface (10) of the deviating prism (9) or the mirror surface in the recess (7) faces outwards and the lower lateral edge of the deviating prism (9) or of the deviating mirror seals the lens head (2) towards the axially outer end (8), and wherein further the light exits (15, 16) of the illuminating device are arranged in the flange-type webs (13, 14).

7. Apparatus according to any one of claims 1 to 6,
**characterised in that**
the illuminating device (15, 16) comprises at least one glass fibre bundle which is connectable with its first axial end to a light source and forms with its second axial end the light exit (15, 16) of the illuminating device on the lens head (2).

8. Apparatus according to any one of claims 1 to 7,
**characterised in that**
the image transmission unit (4) comprises at least one glass fibre bundle (18) which is optically couplable with its first end to the unit for image deviation, in particular the deviating prism (9), and with its second end to the ocular unit (3) .

9. Apparatus according to any one of claims 1 to 8,
**characterised by**
a second illuminating device which is positionable substantially in viewing direction of the apparatus (1) opposite the lens head (2) and illuminates in the direction of the lens head (2).

10. Apparatus according to claim 9,
**characterised in that**
the second illuminating device comprises a counterlight head (23) with a housing (24) with at least one laterally open recess (25) tapering towards the axially outer end of the counterlight head (23), wherein in the housing (24) a deviating prism (26) or a deviating mirror, which is optically couplable to a light source via a glass fibre bundle (27), is disposed in such a way that the free surface of the deviating prism (26) or the mirror surface in the recess (25) faces outwards and the lower lateral edge of the deviating prism (26) or of the deviating mirror seals the counterlight head (23) towards the axially outer end.

11. Apparatus according to claim 9,
**characterised in that**
the second illuminating device comprises a counterlight head (23) which is of substantially identical construction to the lens head (2).

12. Apparatus according to any one of claims 9 to 11,
**characterised in that**
the glass fibre bundle (27) at least of the second illuminating device runs in a flexible spiral tube (28).

13. Apparatus according to any one of claims 9 to 12,
**characterised in that**
the glass fibre bundle of the lens head (2) and of the counterlight head (23) are connectable to the same light source.

14. Apparatus according to any one of claims 1 to 13,
**characterised in that**
the first and/or the second illuminating device or the light source of the first and/or second illuminating device are adjustable in their luminous strength or light intensity.

15. Apparatus according to any one of claims 9 to 14,
**characterised in that**
the lens head (2) and the second illuminating device are couplable via a linkage, rack or similar in such a way that an exactly defined relative position of lens head (2) and second illuminating device, in particular counterlight head (23), is adjustable.

16. Apparatus according to claim 15,
**characterised in that**
the linkage or rack comprises a freely projecting bracket (29) which is fixable substantially rigidly to a housing section (5) of the apparatus (1) between lens head (2) and ocular unit (3) or is part of said housing section (5), wherein the bracket (29) comprises, displaceable in longitudinal direction in a guide element (30), a holding device (31) in which the second illuminating device is fixable, with which the axial distance between lens head (2) and counterlight head (23) is adjustable.

17. Apparatus according to any of claims 1 to 16,
**characterised in that**
an image-recording, image-converting and/or image-processing device of an electronic, optical or magnetic kind is couplable indirectly or directly with image transmission in the area of the ocular unit (3).

18. Method for checking the quality of the soldered joint between an electric or electronic component disposed on the surface of a printed circuit board or similar and the printed circuit board, with the use of the apparatus according to any one of the preceding claims, in which the component comprises, arranged in rows and gaps after the manner of a matrix, a large number of solder pins, solder balls or solder points which are solderable with a corresponding number of contact points complementary as to shape and function disposed on the printed circuit board, with the following method steps:
a) visual examination of the soldered joints of the outermost row of soldered joints of a first side of the component to be tested, wherein the component is moved step-wise according to the spacing of the solder point rows or gaps past the lens head of the apparatus or, conversely, the lens head of the apparatus is moved step-wise past the component;
b) rotation of the component or the apparatus through respectively 90 degrees and visual examination analogously to method step a) of the soldered joints of the outermost rows of soldered joints of the further sides of the component; and
c) visual examination of the channels formed between the respective gaps or rows for optical visibility.

19. Method according to claim 18, **characterised in that** the electric or electronic component is an SMD or BGA.

20. Method according to claim 18 or 19,
**characterised in that**
method step c) is performed with counterlight.

21. Method according to claim 18, 19 or 20,
**characterised in that**
in addition to method steps a) and b), at the same time or staggered in time, the soldered joints of the inner rows are examined visually for soldering defects by viewing into the channels formed between the gaps or rows.

## Revendications

1. Dispositif d'inspection optique en particulier de liaisons brasées (21) cachées, en particulier entre d'une part un composant (20) électrique ou électronique, disposé sur la surface d'un circuit imprimé (19), et d'autre part ce circuit imprimé (19), avec une unité d'oculaire (3), une tête d'objectif (2), une unité de transmission d'image (4) pour transmettre l'image captée par la tête d'objectif (2) à l'unité d'oculaire (3), et une unité d'illumination (15, 16) pour illuminer les liaisons brasées (21) à examiner, la tête d'objectif (2) présentant un dispositif de déviation d'image (9) s'étendant jusqu'à la terminaison axialement extrême de la tête d'objectif (2), et le dispositif d'illumination (15, 16) étant disposé dans la tête d'objectif (2) de manière que l'angle de sortie de la lumière du dispositif d'illumination (15, 16) hors de la tête d'objectif (2) soit sensiblement égal à l'angle de déviation du dispositif de déviation d'image (9), et le site de sortie de la lumière est disposé sur le côté du dispositif de déviation d'image (9), dans la zone de la terminaison axialement extrême de la tête d'objectif (2).

2. Dispositif selon la revendication 1, **caractérisé en ce que** la sortie (15, 16) de la lumière du dispositif d'illumination hors de la tête d'objectif (2) se fait des deux côtés, à côté du dispositif de déviation d'image (9).

3. Dispositif selon la revendication 1 ou 2, **caractérisé en ce que** le dispositif de déviation d'image présente au moins un prisme de déviation (9), ou au moins un miroir de déviation.

4. Dispositif selon l'une des revendications 1 à 3, **caractérisé en ce que** l'angle de déviation du dispositif de déviation d'image (9) est compris entre 0 et 180 degrés, de préférence est sensiblement de 90 degrés.

5. Dispositif selon l'une des revendications 1 à 4, **caractérisé en ce que** l'objectif est conçu de manière que, en particulier présente une distance focale telle que, la plage de profondeur de champ de l'image correspond au moins à la moitié de la taille du composant.

6. Dispositif selon l'une des revendications 1 à 5, **caractérisé en ce que** la tête d'objectif (2) présente un boîtier (6) avec au moins un évidement (7) ouvert latéralement et allant jusqu'à la terminaison axialement extrême de la tête d'objectif (2), évidement délimité des deux côtés par des nervures (13, 14) formant flasque, le prisme de déviation (9) ou le miroir de déviation étant disposé dans le boîtier (6), de manière que la surface libre (10) du prisme de déviation (9) ou la surface réfléchissante dans l'évidement (7) soit tournée vers l'extérieur et que l'arête latérale inférieure du prisme de déviation (9) ou du miroir de déviation délimite la tête d'objectif (2) à la terminaison axialement extrême (8) et en outre, les sorties de lumière (15, 16) du dispositif d'illumination étant disposées dans les nervures (13, 14) formant flasque.

7. Dispositif selon l'une des revendications 1 à 6, **caractérisé en ce que** le dispositif d'illumination (15, 16) présente au moins un faisceau de fibres de verre qui peut être raccordé, par sa première extrémité axiale, à une source de lumière, et qui forme, avec sa deuxième extrémité axiale, la sortie de lumière (15, 16) du dispositif d'illumination sur la tête d'objectif (2).

8. Dispositif selon l'une des revendications 1 à 7, **caractérisé en ce que** l'unité de transmission d'image (4) présente au moins un faisceau de fibres de verre (18) qui peut être couplé optiquement, par sa première extrémité, à l'unité de déviation d'image, en particulier le prisme de déviation (9) et, par sa deuxième extrémité, à l'unité d'oculaire (3).

9. Dispositif selon l'une des revendications 1 à 8, **caractérisé par** un deuxième dispositif d'illumination, pouvant être positionné sensiblement en face de la tête d'objectif (2) dans la direction d'observation du dispositif (1) et illuminant dans la direction allant vers la tête d'objectif (2).

10. Dispositif selon la revendication 9, **caractérisé en ce que** le deuxième dispositif d'illumination présente une tête de contre-éclairage (23) avec un boîtier (24), ayant au moins un évidement (25) ouvert latéralement et allant jusqu'à la terminaison axialement extrême de la tête de contre-éclairage (23), un prisme de déviation (26) ou un miroir de déviation, pouvant être couplé optiquement à une source lumineuse par un faisceau de fibres de verre (27), étant disposé dans le boîtier (24), de manière que la surface libre du prisme de déviation (26) ou la surface réfléchissante dans l'évidement (25) soit tournée vers l'extérieur, et l'arête latérale inférieure du prisme de déviation (26) ou du miroir de déviation délimitant la tête de contre-éclairage (23) à la terminaison axialement extrême.

11. Dispositif selon la revendication 9, **caractérisé en ce que** le deuxième dispositif d'illumination présente une tête de contre-éclairage (23) de conception sensiblement identique à la tête d'objectif (2).

12. Dispositif selon l'une des revendications 9 à 11, **caractérisé en ce que** le faisceau de fibres de verre (27) au moins du deuxième dispositif d'illumination s'étend dans un tuyau flexible à hélice (28).

13. Dispositif selon l'une des revendications 9 à 12, **caractérisé en ce que** les faisceaux de fibres de verre de la tête d'objectif (2) et de la tête de contre-éclairage (23) peuvent être raccordés à la même source de lumière.

14. Dispositif selon l'une des revendications 1 à 13, **caractérisé en ce que** le premier et/ou le deuxième dispositif d'illumination ou la source de lumière du premier ou deuxième dispositif d'illumination peuvent être réglés quant à leur intensité d'illumination ou intensité de lumière.

15. Dispositif selon l'une des revendications 9 à 14, **caractérisé en ce que** la tête d'objectif (2) et le deuxième dispositif d'illumination sont susceptibles d'être couplés au moyen d'une tringlerie, d'un bâti ou analogue, de manière à pouvoir régler une position relative définie précisément de la tête d'objectif (2) et du deuxième dispositif d'illumination, en particulier de la tête de contre-éclairage (23).

16. Dispositif selon la revendication 15, **caractérisé en ce que** la tringlerie ou le bâti présente un support (29), susceptible d'être fixé pratiquement rigidement, en étant en porte-à-faux libre sur un tronçon de boîtier (5) du dispositif (1), entre la tête d'objectif (2) et l'unité d'oculaire (3), ou fait partie de ce tronçon de boîtier (5), le support (29) présentant un élément support (31) déplaçable en direction longitudinale dans un guidage (30), dans lequel le deuxième dispositif d'illumination peut être fixé, avec lequel l'espacement axial, entre la tête d'objectif (2) et la tête de contre-éclairage (23), peut être réglé.

17. Dispositif selon l'une des revendications 1 à 16, **caractérisé en ce qu'**un dispositif d'enregistrement d'image, de conversion d'image et/ou de traitement d'image, de nature électronique, optique ou magnétique, peut être couplé dans la zone de l'unité d'oculaire (3) en transmettant l'image directement ou indirectement.

18. Procédé d'examen de la qualité de la liaison brasée entre d'une part un composant électrique ou électronique disposé sur la surface d'un circuit imprimé ou analogue, et d'autre part ce circuit imprimé, avec utilisation du dispositif selon l'une des revendications précédentes, le composant présentant une pluralité de pattes de brasage, de billes de brasage ou de points de brasage, disposées à la façon d'une matrice, en rangées et en colonnes, pouvant être brasé(e)s avec un nombre correspondant de points de contact disposés sur le circuit imprimé, de façon complémentaire du point de vue de la forme et de la fonction, avec les étapes de procédé suivantes :
a) examen optique des liaisons brasées de la rangée la plus extérieure des liaisons brasées d'un premier côté du composant à examiner, le composant étant passé pas à pas, de manière correspondante à l'espacement des rangées ou des colonnes de points de brasage, sur la tête d'objectif du dispositif ou bien, à l'inverse, la tête d'objectif du dispositif étant passée pas à pas sur le composant ;
b) rotation du composant et du dispositif chaque fois de 90 degrés et examen optique, de façon analogue à l'étape de procédé a), des liaisons brasées des rangées les plus extérieures des liaisons brasées des autres côtés du composant ; et
c) examen optique des canaux chaque fois formés entre les colonnes ou les rangées, pour vérifier qu'ils sont dégagés.

19. Procédé selon la revendication 18, **caractérisé en ce que** le composant électrique ou électronique est un SMD ou BGA.

20. Procédé selon l'une des revendications 18 et 19, **caractérisé en ce que** l'étape de procédé c) est conduite en contre-éclairage.

21. Procédé selon la revendication 18, 19 ou 20, **caractérisé en ce que**, en plus des étapes de procédé a) et b), on examine, de façon simultanée ou temporellement décalée, la liaison brasée des rangées intérieures, par inspection optique dans les canaux formés entre les colonnes ou les rangées, pour détecter les défauts de brasure.
